# DEMANDE DE BREVET EUROPEEN

(11) **EP 3 582 268 A1**
(43) Date de publication de la demande: **18.12.2019**
(21) Numéro de dépôt: 19178967.6
(22) Date de dépôt: 07.06.2019
(51) Int. Cl.: H01L 31/0465, H01L 31/0463, H01L 31/18

(54) **PROCÉDÉ DE FABRICATION D'UN MODULE PHOTOVOLTAÏQUE ET MODULE PHOTOVOLTAÏQUE AINSI OBTENU**

(30) Priorité: 11.06.2018 FR 1855064
(71) Demandeur: Armor, 44100 Nantes (FR)
(72) Inventeur: ALLAIS, François, 44115 BASSE GOULAINE (FR); HAU, Damien, 44115 BASSE GOULAINE (FR); MWAURA, Jeremiah, ANDOVER, MA 01810 (US)
(74) Mandataire: Lavoix

(57) **Abrégé**

La présente invention concerne un procédé de fabrication d'un module photovoltaïque (10), comprenant au moins deux cellules photovoltaïques (16A, 16B, 16C) connectées électriquement, ledit module comprenant un substrat isolant (12) recouvert d'une couche d'un premier matériau conducteur (19).

Le procédé comprend : a) la formation d'un sillon (36A, 36B) définissant une première (18A) et une deuxième (18B) électrodes inférieures; et b) la formation, sur chaque électrode inférieure, d'un empilement (20) comprenant une électrode supérieure (22) et une couche (24) photo-active.

Le procédé comprend en outre, entre les étapes a) et b), la formation : d'une première bande isolante (42) sur le sillon ; puis d'une bande conductrice (46) recouvrant partiellement ladite première bande isolante ; puis d'une deuxième bande isolante (44) recouvrant partiellement ladite bande conductrice.

## Description

La présente invention concerne un procédé de fabrication d'un module photovoltaïque, du type comprenant au moins deux cellules photovoltaïques connectées électriquement, ledit module comprenant un substrat isolant recouvert d'une couche d'un premier matériau conducteur ; le procédé comprenant les étapes suivantes : a) formation, sur la couche de premier matériau, d'un sillon définissant une première et une deuxième électrodes inférieures, isolées l'une de l'autre ; et b) formation, sur chacune desdites électrodes inférieures, d'un empilement comprenant au moins : une électrode supérieure formée d'une couche d'un deuxième matériau conducteur ; et au moins une couche photo-active disposée entre les électrodes inférieure et supérieure ; chacune des première et deuxième électrodes inférieures formant respectivement une première et une deuxième cellules photovoltaïques avec l'empilement correspondant.

Un module photovoltaïque est un composant électronique qui, exposé à la lumière, produit de l'électricité. Un tel module photovoltaïque comprend typiquement plusieurs cellules photovoltaïques connectées électriquement. Chaque cellule comporte au moins un matériau photo-actif, c'est-à-dire apte à produire de l'électricité à partir de la lumière. Un tel matériau est par exemple un semi-conducteur organique.

Des modules photovoltaïques du type précité sont décrits dans les documents US7932124 et EP2478559. Chaque cellule d'un tel module photovoltaïque est formée d'un empilement de bandes, comportant une couche photo-active entre deux électrodes, ledit empilement de bandes étant disposé sur un support.

Un tel empilement, dit zone active, est séparé des zones actives voisines par une zone dite inactive. Ladite zone inactive permet d'isoler électriquement les électrodes inférieures de deux cellules voisines tout en reliant l'électrode supérieure de chaque cellule à l'électrode inférieure d'une cellule voisine. Un module photovoltaïque est obtenu par la formation de plusieurs cellules ainsi connectées en série.

Généralement, dans les méthodes de production à grande échelle, les couches des empilements sont réalisées par voie humide, c'est-à-dire par dépôt d'une formulation liquide suivie d'un passage à l'état solide.

La performance du module photovoltaïque passe notamment par la réalisation de zones inactives les plus étroites possibles, pour maximiser la taille des zones actives. Le facteur de remplissage géométrique, ou GFF (*Geometric Fill-Factor*) du module photovoltaïque est défini comme un ratio entre la somme des aires des zones actives des cellules photovoltaïques et une aire totale du substrat. Plus le GFF est élevé, plus le module photovoltaïque est électriquement performant. L'obtention d'un GFF élevé impose notamment de maîtriser la géométrie des connexions électriques.

Cependant, les propriétés rhéologiques et de mouillabilité des formulations, ainsi que les propriétés physiques des supports, induisent des effets de bords sur les bandes déposées par voie humide. Dans le document US7932124, les couches de l'empilement formant chaque cellule sont notamment réalisées avec des largeurs décroissantes, de sorte à ménager un décalage latéral en marches d'escalier. Un tel procédé de réalisation complexifie sa mise en oeuvre par des méthodes de production à grande échelle et contribue à diminuer la taille des zones actives.

Dans le document EP2478559, l'empilement est tout d'abord réalisé de manière uniforme sur l'ensemble du module, puis différents sillons sont formés dans les couches afin de constituer les zones inactives. Ce procédé nécessite des moyens d'ablation sélective, les différents sillons ayant des profondeurs différentes selon leur rôle dans la zone inactive.

La présente invention a pour but de proposer un procédé de fabrication d'un module photovoltaïque simple à mettre en oeuvre, tout en minimisant la taille des zones inactives afin de maximiser celle des zones actives.

A cet effet, l'invention a pour objet un procédé de fabrication du type précité, dans lequel : l'étape b) est réalisée après l'étape a) ; le procédé comprend les étapes suivantes : c) formation d'une première bande isolante sur la couche de premier matériau, de sorte à recouvrir un emplacement du sillon ; ladite première bande comprenant une première et une seconde portions adjacentes, respectivement orientées vers la première et vers la deuxième électrodes inférieures ; puis d) formation d'une bande conductrice sur la couche de premier matériau, ladite bande conductrice recouvrant la seconde portion et laissant libre la première portion de la première bande isolante ; ladite bande conductrice comprenant une première et une seconde portions adjacentes, respectivement orientées vers la première et vers la deuxième électrodes inférieures, ladite première portion formant un relief par rapport à la première bande isolante ; puis e) formation d'une deuxième bande isolante sur la couche de premier matériau, ladite deuxième bande recouvrant la seconde portion et laissant libre la première portion de la bande conductrice ; au moins les étapes d) et e) étant réalisées entre les étapes a) et b). Par ailleurs, à l'étape b), les électrodes supérieures de la première et de la deuxième cellules photovoltaïques sont respectivement formées en contact avec, et à l'écart de, la première portion de la bande électriquement conductrice.

Suivant d'autres aspects avantageux de l'invention, le procédé de fabrication comporte l'une ou plusieurs des caractéristiques suivantes, prises isolément ou suivant toutes les combinaisons techniquement possibles :
- l'étape c) est réalisée entre les étapes a) et b), la première bande isolante étant en outre formée dans le sillon ;
- l'une au moins des première et deuxième bandes isolantes est réalisée par dépôt d'une première formulation liquide comprenant des matériaux électriquement isolants, suivi d'un passage à l'état solide de ladite première formulation ;
- la bande conductrice est réalisée par dépôt d'une deuxième formulation liquide comprenant des matériaux électriquement conducteurs, suivi d'un passage à l'état solide de ladite deuxième formulation ;
- le passage à l'état solide de la deuxième formulation comprend un chauffage à une température supérieure à 120 °C;
- l'une au moins des première et deuxième bandes isolantes et de la bande conductrice est formée par une technique d'enduction ou d'impression au déroulé par voie humide, préférentiellement choisie parmi le slot-die, l'héliogravure, la flexographie et la sérigraphie rotative.

L'invention se rapporte en outre à un module photovoltaïque issu ou susceptible d'être issu d'un procédé tel que décrit ci-dessus.

Suivant d'autres aspects avantageux de l'invention, le module photovoltaïque comporte l'une ou plusieurs des caractéristiques suivantes, prises isolément ou suivant toutes les combinaisons techniquement possibles :
- les première et deuxième bandes isolantes et la bande conductrice forment avec le sillon une zone inactive séparant deux cellules photovoltaïques adjacentes, une largeur de la zone inactive étant comprise entre 0,30 mm et 1,60 mm ;
- une largeur de l'une au moins des première et deuxième bandes isolantes est comprise entre 100 µm et 800 µm;
- une largeur de la bande conductrice est comprise entre 200 µm et 900 µm.

L'invention sera mieux comprise à la lecture de la description qui va suivre, donnée uniquement à titre d'exemple non limitatif et faite en se référant aux dessins sur lesquels :
- la figure 1 est une vue schématique, en coupe, d'un module photovoltaïque selon un mode de réalisation de l'invention ;
- les figures 2 à 4 représentent schématiquement des étapes de fabrication du module photovoltaïque de la figure 1, par un procédé selon un mode de réalisation de l'invention ; et
- la figure 5 est une vue de détail de l'étape de fabrication de la figure 4.

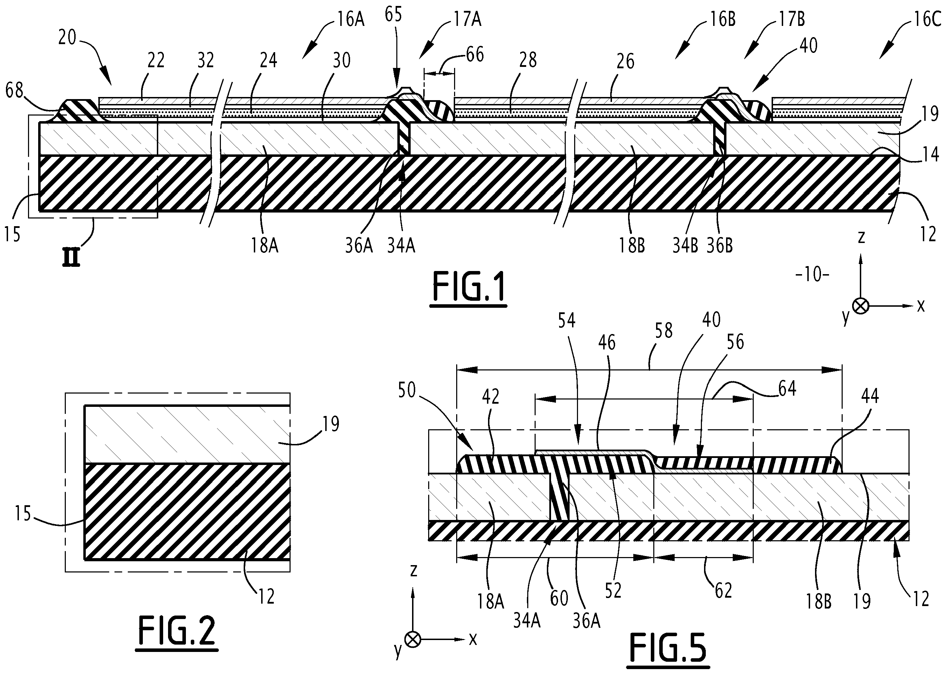

La figure 1 représente une vue en coupe d'un module photovoltaïque 10 selon un mode de réalisation de l'invention.

Le module photovoltaïque 10 comporte notamment un substrat 12, formé d'un film de matériau électriquement isolant et transparent à la lumière visible, notamment de type polymère. Le substrat 12 comporte notamment une surface 14 sensiblement plane, délimitée par au moins un bord 15.

On considère une base orthonormée (X, Y, Z), la surface 14 formant un plan (X, Y). Sur la figure 1, le module photovoltaïque 10 est représenté avec des dimensions selon Z étirées par rapport aux dimensions selon X.

Le module photovoltaïque 10 comporte au moins deux cellules photovoltaïques 16A, 16B, 16C, disposées sur le substrat 12. Le module photovoltaïque 10 comporte en outre au moins une connexion électrique 17A, 17B entre deux cellules photovoltaïques.

Chacune des cellules photovoltaïques 16A, 16B, 16C est formée par un empilement de bandes disposées longitudinalement selon la direction Y. Une longueur des bandes selon Y peut aller jusqu'à plusieurs centaines de mètres.

De préférence, le module photovoltaïque 10 comporte une pluralité de cellules photovoltaïques 16A, 16B, 16C, par exemple un nombre de cellules photovoltaïques supérieur à trois. Le module photovoltaïque 10 comporte préférentiellement quatre, neuf ou vingt cellules photovoltaïques en forme de bandes, le nombre de cellules n'étant pas contraint à ces seules valeurs.

Les cellules photovoltaïques 16A, 16B, 16C sont sensiblement identiques et adjacentes selon la direction X. Les cellules adjacentes sont reliées par une connexion électrique 17A, 17B.

Une première cellule photovoltaïque 16A est adjacente selon X à un bord 15 du substrat 12, ledit bord 15 s'étendant sensiblement selon Y. Une deuxième cellule photovoltaïque 16B est disposée entre la première 16A et une troisième 16C cellules photovoltaïques. Ladite deuxième cellule 16B est connectée électriquement à chacune desdites première 16A et troisième 16C cellules, respectivement par une première 17A et par une deuxième 17B connexions électriques.

Les première 16A et deuxième 16B cellules photovoltaïques seront décrites simultanément ci-après. La troisième cellule photovoltaïque 16C, partiellement représentée sur la figure 1, est considérée comme identique à la deuxième cellule photovoltaïque 16B.

Chaque cellule photovoltaïque 16A, 16B comporte une électrode inférieure 18A, 18B, au contact de la surface 14 du substrat 12. L'électrode inférieure 18A, 18B est formée d'une couche d'un premier matériau électriquement conducteur 19, transparent à la lumière visible. A titre indicatif, l'électrode inférieure 18A, 18B présente une largeur selon X comprise entre 10 mm et 20 mm et une épaisseur selon Z préférentiellement inférieure à 1 µm. Plus préférentiellement, ladite épaisseur est comprise entre 50 et 500 nm.

Chaque cellule photovoltaïque 16A, 16B comporte en outre un empilement 20 de couches de matériaux, disposé sur l'électrode inférieure 18A, 18B. L'empilement 20 comprend au moins une électrode supérieure 22 et une couche photo-active 24.

L'électrode supérieure 22 est formée d'une couche d'un deuxième matériau électriquement conducteur 26, notamment métallique, préférentiellement transparent à la lumière visible. Il s'agit par exemple d'une encre à base de nanoparticules d'argent ou de nanofils d'argent.

La couche photo-active 24, disposée entre les électrodes inférieure 18A, 18B et supérieure 22, est constituée d'un matériau photo-actif 28. Le matériau photo-actif 28 est de type semi-conducteur. Il s'agit de préférence d'un semi-conducteur organique. Avantageusement, le matériau photo-actif 28 est constitué d'un mélange d'au moins un matériau donneur d'électrons, dit matériau de type p, et d'au moins un matériau accepteur d'électrons, dit matériau de type n. Le matériau photo-actif 28 est par exemple un mélange intime, à l'échelle nanométrique, desdits matériaux de type p et n. Alternativement, la couche photo-active 24 peut être une hétérojonction de matériaux de type p et de matériaux de type n, sous la forme d'une couche ou d'un empilement de plusieurs couches.

Dans le mode de réalisation de la figure 1, l'empilement 20 comporte en outre une première 30 et une deuxième 32 couches d'interface, ayant un rôle de transport d'électrons ou de trous entre les électrodes 18A, 18B, 22 et la couche photo-active 24. Chaque couche d'interface 30, 32 est disposée entre ladite couche photo-active 24 et l'une des électrodes inférieure 18A, 18B ou supérieure 22.

Chacune des différentes couches de l'empilement 20 a préférentiellement une épaisseur selon Z inférieure à 10 µm, plus préférentiellement inférieure à 1 µm.

Chaque cellule photovoltaïque 16A, 16B, 16C est séparée de la ou de chaque cellule photovoltaïque adjacente par une zone inactive 34A, 34B. Par exemple, les première 16A et deuxième 16B cellules photovoltaïques sont séparées par la zone inactive 34A ; la deuxième cellule photovoltaïque 16B est délimitée selon X par les zones inactives 34A et 34B.

En particulier, les électrodes inférieures 18A, 18B sont formées par les surfaces de premier matériau électriquement conducteur 19 située à l'écart des zones inactives 34A, 34B. Lesdites surfaces définissent les zones dites actives du module photovoltaïque 10, correspondant aux cellules photovoltaïques 16A, 16B, 16C en tant que telles.

Comme indiqué précédemment, plus le facteur de remplissage géométrique, ou GFF, est élevé, plus le module photovoltaïque 10 est électriquement performant. Comme décrit ci-après, le module photovoltaïque selon la présente invention permet de minimiser la largeur des zones inactives, de sorte à maximiser la taille des zones actives pour une même taille de substrat, et ainsi à optimiser le GFF.

Chaque zone inactive 34A, 34B comprend un sillon 36A, 36B séparant deux électrodes inférieures adjacentes. Par exemple, le sillon 36A est situé entre les première 18A et deuxième 18B électrodes inférieures des première 16A et deuxième 16B cellules photovoltaïques ; la deuxième électrode inférieure 18B est disposée entre les sillons 36A et 36B.

Un fond du sillon 36A, 36B est formé par le substrat 12 électriquement isolant. Ainsi, chaque sillon 36A, 36B isole électriquement les électrodes inférieures situées de part et d'autre dudit sillon. A titre indicatif, le sillon 36A, 36B présente une largeur selon X comprise entre 20 µm et 50 µm, préférentiellement entre 30 et 40 µm.

Chaque zone inactive 34A, 34B comprend en outre un assemblage 40 au contact du sillon 36A, 36B correspondant. La figure 5 représente une vue de détail d'une zone inactive 34A, les dimensions selon Z étant moins étirées que sur la figure 1 par rapport aux dimensions selon X. La description ci-après de la zone inactive 34A est valable pour les autres zones inactives du module photovoltaïque 10.

L'assemblage 40 comprend une première 42 et une deuxième 44 bandes électriquement isolantes, ainsi qu'une bande électriquement conductrice 46, lesdites bandes 42, 44, 46 s'étendant selon Y.

La première bande électriquement isolante 42 s'étend dans le sillon 36A et de part et d'autre dudit sillon, sur la couche de premier matériau électriquement conducteur 19. Ladite première bande électriquement isolante 42 comporte une première 50 et une seconde 52 portions adjacentes selon X. Lesdites première 50 et seconde 52 portions sont respectivement orientées vers la première 16A et vers la deuxième 16B cellules photovoltaïques.

La bande électriquement conductrice 46 s'étend sur la seconde portion 52 de la première bande électriquement isolante 42, ainsi que sur le premier matériau électriquement conducteur 19. La bande électriquement conductrice 46 est au contraire disposée à l'écart de la première portion 50 de la première bande électriquement isolante 42.

La bande électriquement conductrice 46 comporte elle-même une première 54 et une seconde 56 portions adjacentes selon X, respectivement orientées vers la première 16A et vers la deuxième 16B cellules photovoltaïques. Ladite première portion 54 forme une saillie selon Z par rapport à la première bande électriquement isolante 42. Ladite seconde portion 56 est au contact du premier matériau électriquement conducteur 19.

La deuxième bande électriquement isolante 44 s'étend sur la seconde portion 56 de la bande électriquement conductrice 46, ainsi que sur le premier matériau électriquement conducteur 19. La deuxième bande électriquement isolante 44 est au contraire disposée à l'écart de la première portion 54 de la bande électriquement conductrice 46.

A titre indicatif, chaque bande électriquement isolante 42, 44 a une épaisseur selon Z comprise entre 5 µm et 40 µm, préférentiellement entre 10 µm et 20 µm; et la bande électriquement conductrice 46 a une épaisseur selon Z comprise entre 1 µm et 10 µm, préférentiellement entre 2 µm et 5 µm.

De manière préférentielle, une largeur 58 selon X de l'assemblage 40, donc de la zone inactive 34A, est comprise entre 0,30 mm et 1,60 mm. Cette faible largeur permet de maximiser la taille des cellules 16A, 16B.

Plus précisément, une largeur 60, 62 selon X de chaque bande électriquement isolante 42, 44 est préférentiellement comprise entre 100 µm et 800 µm. Par ailleurs, une largeur 64 selon X de la bande électriquement conductrice 46 est préférentiellement comprise entre 200 µm et 900 µm.

Comme visible sur la figure 1, les différentes couches de l'empilement 20 formé sur la première électrode inférieure 18A viennent selon X au contact de la première portion 50 de la première bande électriquement isolante 42 de la zone inactive 34A. De préférence, au moins certaines couches de l'empilement 20 formé sur la deuxième électrode inférieure 18B viennent selon X au contact de la deuxième bande électriquement isolante 44 de ladite zone inactive 34A.

La connexion électrique 17A reliant la première 16A et la deuxième 16B cellules photovoltaïques comporte une jonction 65 entre l'électrode supérieure 22 de ladite première cellule 16A et la première portion 50 de la bande électriquement conductrice 46 de la zone inactive 34A. L'électrode supérieure 22 de ladite première cellule 16A est ainsi électriquement reliée à la deuxième électrode inférieure 18B, par l'intermédiaire de ladite bande électriquement conductrice 46.

Au contraire, un espace 66 selon X (figure 1) est ménagé entre la bande électriquement conductrice 46 de la zone inactive 34A et l'électrode supérieure 22 de la deuxième cellule photovoltaïque 16B.

Par ailleurs, la première cellule photovoltaïque 16A, adjacente au bord 15 du substrat 12, est séparée dudit bord 15 par une zone inactive d'extrémité 68, formée d'une bande électriquement isolante s'étendant selon Y le long dudit bord. A titre indicatif, la zone inactive d'extrémité 68 a une épaisseur selon Z comprise entre 10 µm et 20 µm et une largeur selon X comprise entre 400 µm et 800 µm. De préférence, au moins certaines couches de l'empilement 20 formé sur la première électrode inférieure 18A viennent selon X au contact de la zone inactive d'extrémité 68.

Un procédé de fabrication du module photovoltaïque 10 ci-dessus va maintenant être décrit, sur la base des figures 2 à 5 :
Tout d'abord (figure 2) est fourni le substrat 12 recouvert d'une couche du premier matériau électriquement conducteur 19. Ledit matériau 19 est par exemple déposé sur la surface 14 du substrat 12 par enduction de type pleine surface.

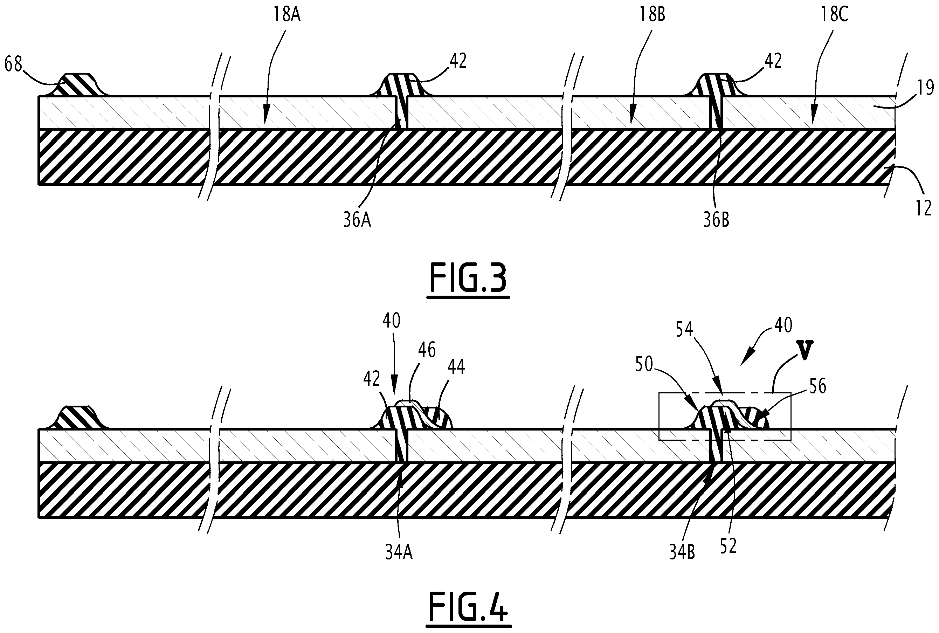

Les sillons 36A, 36B sont formés sur ladite couche de matériau 19, notamment par gravure mécanique ou laser. Une première bande électriquement isolante 42 est formée au niveau de chaque sillon 36A, 36B et de part et d'autre dudit sillon, sur le matériau 19 (figure 3). De même, la zone inactive d'extrémité 68 est formée sur le matériau 19, le long du bord 15.

Selon le mode de réalisation représenté, les sillons 36A, 36B sont tout d'abord formés ; puis chaque première bande électriquement isolante 42 est réalisée dans le sillon 36A, 36B correspondant et de part et d'autre dudit sillon.

Chacune des premières bandes électriquement isolantes 42 permet d'achever l'isolation électrique entre les cellules photovoltaïques adjacentes. En effet, la formation d'une bande électriquement isolante 42 dans un sillon 36A, 36B permet de minimiser les courts-circuits éventuels entre les électrodes inférieures 18A, 18B voisines. De tels courts-circuits sont notamment induits par des débris générés lors de la formation du sillon par gravure.

Selon une variante de réalisation non représentée, chaque première bande électriquement isolante 42 est réalisée sur l'emplacement prévu pour le sillon 36A, 36B correspondant, puis chaque sillon est formé par gravure laser, à travers ladite première bande électriquement isolante 42.

En effet, la gravure laser ne produit pas de débris pouvant générer des courts-circuits. Par ailleurs, le système de gravure laser permet de graver le matériau 19 à travers la bande isolante 42. En effet, le matériau de la bande isolante 42 étant transparent à la longueur d'onde du laser, cette bande 42 reste intacte ; tandis que l'énergie du rayon laser étant absorbée par le matériau 19, elle permet de graver ce matériau.

Il est ainsi possible de graver un sillon 36A, 36B sous une bande isolante 42 préalablement formée.

Après formation d'un sillon 36A, 36B et d'une première bande électriquement isolante 42 correspondante, la bande électriquement conductrice 46 et la deuxième bande électriquement isolante 44 sont réalisées, pour former l'assemblage 40 correspondant à chaque zone inactive 34A, 34B (figures 4 et 5).

De préférence, la première bande électriquement isolante 42 et/ou la zone inactive d'extrémité 68 sont réalisées par dépôt d'une première formulation liquide comprenant des matériaux électriquement isolants, suivie d'un passage à l'état solide de ladite première formulation.

De préférence, la bande électriquement conductrice 46 et la deuxième bande électriquement isolante 44 sont réalisées par dépôt, respectivement, d'une deuxième et d'une troisième formulations liquides, suivie d'un passage à l'état solide de ladite deuxième/troisième formulation.

La première et/ou la troisième formulations liquides comprennent par exemple des polymères préparés à partir de matériaux tels que des amines, des acrylates, des époxydes, des uréthanes, des phénoxys ou des combinaisons de ceux-ci. Ces matériaux isolants sont déposés en solution, ou encore sans solvant lorsqu'ils sont à l'état liquide à température ambiante. Selon un mode de réalisation, les première et troisième formulations sont sensiblement identiques.

La deuxième formulation liquide comporte au moins un matériau électriquement conducteur, qui peut être choisi parmi : les métaux et alliages électriquement conducteurs, notamment l'or, l'argent, le cuivre, l'aluminium, le nickel, le palladium, le platine et le titane ; les polymères conducteurs tels que les polythiophènes, les polyanilines, les polypyrroles ; et les oxydes métalliques tels que l'oxyde d'indium et d'étain, l'oxyde d'étain fluoré, l'oxyde d'étain, l'oxyde de zinc et le dioxyde de titane. La deuxième formulation liquide comporte optionnellement un solvant.

Il est à noter que, l'assemblage 40 étant réalisé avant l'empilement 20, les éventuels solvants entrant dans la composition des première, deuxième et troisième formulations liquides peuvent être choisi parmi les solvants non orthogonaux audit empilement 20. En effet, le procédé selon l'invention élimine le risque d'attaquer ou de dissoudre l'empilement 20 lors de la formation de l'assemblage 40.

Au moins l'une des première 42 ou deuxième 44 bandes électriquement isolantes ou bande électriquement conductrice 46 est réalisée par une technique d'enduction ou d'impression au déroulé par voie humide, préférentiellement choisie parmi le slot-die, l'héliogravure, la flexographie et la sérigraphie rotative. La précision de ces techniques permet en particulier de former la bande électriquement conductrice 46 de sorte à définir la géométrie souhaitée pour les première 50 et seconde 52 portions de la première bande électriquement isolante 42, ainsi que de former la deuxième bande électriquement isolante 44 de sorte à définir la géométrie souhaitée pour les première 54 et seconde 56 portions de la bande électriquement conductrice 46.

De manière optionnelle, les deuxième et troisième formulations liquides sont déposées successivement, puis passées simultanément à l'état solide, pour former la bande électriquement conductrice 46 et la deuxième bande électriquement isolante 44.

Le passage à l'état solide de la deuxième formulation liquide est de préférence réalisé par chauffage, notamment à des températures supérieures à 120 °C, ou encore par exposition à des rayons infra-rouges ou ultra-violets. Les mêmes techniques peuvent être utilisées pour le passage à l'état solide des première et troisième formulations liquides. Alternativement, lesdites première et troisième formulations liquides sont séchées à température ambiante ou par chauffage inférieur à 120 °C.

Ensuite, l'empilement 20 de couches 30, 24, 32, 22 de matériaux est réalisé au niveau de chaque électrode inférieure 18A, 18B. Chaque couche de l'empilement 20 peut être formée grâce à une large gamme de techniques. Les méthodes de fabrication compatibles avec la production à grande échelle sont de préférence des procédés continus tels que les procédés au déroulé ou roll-to-roll.

Chacune des différentes couches 30, 24, 32, 22 des empilements 20 est de préférence formée par une technique d'enduction ou d'impression au déroulé par voie humide, notamment choisie parmi l'enduction par filière plate souvent désignée sous le terme anglais «slot-die», le revêtement par rideau souvent désigné par l'expression «curtain coating», l'enduction à la racle souvent désignée par l'expression «knife coating», l'héliogravure, l'héliographie, la sérigraphie rotative et la flexographie, puis par un séchage de la couche. Il est à noter qu'après le dépôt de la couche photo-active 24, il est souhaitable de ne pas exposer l'ensemble à des températures supérieures à 120°C sous peine de dégradations. Ainsi, il est avantageux de réaliser les zones inactives 34A, 34B avant l'empilement 20 ; en effet, une température de séchage élevée de la bande électriquement conductrice 46 permet d'améliorer la conductivité de ladite bande, donc de diminuer la résistance en série entre les deux cellules photovoltaïques voisines.

De plus, certaines techniques de formation de l'empilement 20, comme la flexographie, l'héliographie, l'héliogravure, la sérigraphie et le slot-die, mettent en oeuvre des machines comportant des rouleaux d'entraînement. Dans ce cas, les zones inactives 34A, 34B forment une protection physique selon l'axe Z de la surface enduite. Une telle protection permet de limiter la formation de défauts sur les différentes couches enduites, par le contact entre les rouleaux d'entraînement et le substrat à enduire.

La précision des techniques indiquées ci-dessus, pour la formation de l'empilement 20, permet en particulier de ménager l'espace 66 selon X entre la bande électriquement conductrice 46 de la zone inactive 34A et l'électrode supérieure 22 de la deuxième cellule photovoltaïque 16B. Les courts-circuits entre les première 16A et deuxième 16B cellules photovoltaïques sont ainsi évités.

Par ailleurs, la couche formant l'électrode supérieure 22 de la première cellule photovoltaïque 16A est déposée de sorte à former la jonction 65 selon X avec la première portion 54 de la bande électriquement conductrice 46 de la zone inactive 34A, formant la première connexion électrique 17A. La deuxième connexion électrique 17B est formée de manière analogue, entre la deuxième cellule photovoltaïque16B et la zone inactive 34B.

Le module photovoltaïque 10 de la figure 1 est ainsi obtenu.

## Revendications

1. Procédé de fabrication d'un module photovoltaïque (10), comprenant au moins deux cellules photovoltaïques (16A, 16B, 16C) connectées électriquement, ledit module comprenant un substrat isolant (12) recouvert d'une couche d'un premier matériau conducteur (19) ; le procédé comprenant les étapes suivantes :
- a) formation, sur la couche de premier matériau, d'un sillon (36A, 36B) définissant une première (18A) et une deuxième (18B) électrodes inférieures, isolées l'une de l'autre ; et
- b) formation, sur chacune desdites électrodes inférieures, d'un empilement (20) comprenant au moins : une électrode supérieure (22) formée d'une couche d'un deuxième matériau conducteur ; et au moins une couche (24) photo-active disposée entre les électrodes inférieure et supérieure ; chacune des première (18A) et deuxième (18B) électrodes inférieures formant respectivement une première (16A) et une deuxième (16B) cellules photovoltaïques avec l'empilement (20) correspondant ;
le procédé étant **caractérisé en ce que** :
- l'étape b) est réalisée après l'étape a) ;
- le procédé comprend les étapes suivantes :
- c) formation d'une première bande isolante (42) sur la couche de premier matériau, de sorte à recouvrir un emplacement du sillon (36A, 36B) ; ladite première bande comprenant une première (50) et une seconde (52) portions adjacentes, respectivement orientées vers la première et vers la deuxième électrodes inférieures ; puis
- d) formation d'une bande conductrice (46) sur la couche de premier matériau (19), ladite bande conductrice recouvrant la seconde portion (52) et laissant libre la première portion (50) de la première bande isolante ; ladite bande conductrice comprenant une première (54) et une seconde (56) portions adjacentes, respectivement orientées vers la première et vers la deuxième électrodes inférieures, ladite première portion formant un relief par rapport à la première bande isolante ; puis
- e) formation d'une deuxième bande isolante (44) sur la couche de premier matériau, ladite deuxième bande recouvrant la seconde portion (56) et laissant libre la première portion (54) de la bande conductrice ;
au moins les étapes d) et e) étant réalisées entre les étapes a) et b) ; et
- à l'étape b), les électrodes supérieures (22) de la première (16A) et de la deuxième (16B) cellules photovoltaïques sont respectivement formées en contact (65) avec, et à l'écart (66) de, la première portion (50) de la bande électriquement conductrice.

2. Procédé selon la revendication 1, dans lequel l'étape c) est réalisée entre les étapes a) et b), la première bande isolante (42) étant en outre formée dans le sillon (36A, 36B).

3. Procédé selon la revendication 1 ou la revendication 2, dans lequel l'une au moins des première (42) et deuxième (44) bandes isolantes est réalisée par dépôt d'une première formulation liquide comprenant des matériaux électriquement isolants, suivi d'un passage à l'état solide de ladite première formulation.

4. Procédé selon l'une des revendications précédentes, dans lequel la bande conductrice (46) est réalisée par dépôt d'une deuxième formulation liquide comprenant des matériaux électriquement conducteurs, suivi d'un passage à l'état solide de ladite deuxième formulation.

5. Procédé selon la revendication 4, dans lequel le passage à l'état solide de la deuxième formulation comprend un chauffage à une température supérieure à 120 °C.

6. Procédé selon l'une des revendications précédentes, dans lequel l'une au moins des première (42) et deuxième (44) bandes isolantes et de la bande conductrice (46) est formée par une technique d'enduction ou d'impression au déroulé par voie humide, préférentiellement choisie parmi le slot-die, l'héliogravure, la flexographie et la sérigraphie rotative.

7. Module photovoltaïque (10) issu d'un procédé selon l'une des revendications précédentes.

8. Module photovoltaïque selon la revendication 7, dans lequel les première (42) et deuxième (44) bandes isolantes et la bande conductrice (46) forment avec le sillon (36A, 36B) une zone inactive (34A, 34B) séparant deux cellules photovoltaïques (16A, 16B, 16C) adjacentes, une largeur (58) de la zone inactive étant comprise entre 0,30 mm et 1,60 mm.

9. Module photovoltaïque selon la revendication 7 ou la revendication 8, dans lequel une largeur (60, 62) de l'une au moins des première et deuxième bandes isolantes (42, 44) est comprise entre 100 µm et 800 µm.

10. Module photovoltaïque selon l'une des revendications 7 à 9, dans lequel une largeur (64) de la bande conductrice (46) est comprise entre 200 µm et 900 µm.
